Europäisches Patentamt

European Patent Office

Office européen des brevets

(19)

(11) Publication number: 0 359 238
A2

# (12) EUROPEAN PATENT APPLICATION

(21) Application number: 89116962.5

(22) Date of filing: 13.09.89

(51) Int. Cl.5: H01Q 21/00 , H01Q 23/00 , H01Q 3/36

(30) Priority: 13.09.88 JP 230382/88
30.09.88 JP 247225/88

(43) Date of publication of application:
21.03.90 Bulletin 90/12

(84) Designated Contracting States:
DE FR GB IT NL SE

(71) Applicant: NEC CORPORATION
33-1, Shiba 5-chome
Minato-ku Tokyo(JP)

(72) Inventor: Higuchi, Yuji c/o NEC Corporation
33-1, Shiba 5-chome
Minato-ku Tokyo(JP)
Inventor: Shibata, Kazuhide c/o NEC
Engineering Ltd.
20-4, Nishishinbashi 3-chome
Minato-ku Tokyo(JP)
Inventor: Imai, Toshio c/o NEC Corporation
33-1, Shiba 5-chome
Minato-ku Tokyo(JP)

(74) Representative: Vossius & Partner
Siebertstrasse 4 P.O. Box 86 07 67
D-8000 München 86(DE)

(54) Array antenna device having IC units with IF conversion circuits for coupling antenna elements and signal combiner.

(57) An array antenna device comprising an antenna array of a plurality of antenna elements for receiving an radio wave to produce receive signals and a signal combiner for combining the receive signals to produce a combined signal. In order to reduce the combining loss and the transmission loss through the signal combiner, an amplifier and an IF conversion circuit comprising a mixer and a local oscillator are formed in an IC chip. The antenna elements are contained in cases together with a plurality of IC chips, respectively, to form a plurality of units. The units are mounted on circuit board with the signal combiner consisting of micro strip lines. In order to synchronize the local oscillators in the units with one another, a reference signal generator is also formed on the circuit board and is coupled to the local oscillators. Variable phase shifters are used for adjust a direction of the main lobe of the antenna array and are also mounted cn the circuit board. A similar structure is applicable to an array antenna device for radiating a transmission signal.

FIG.9

# ARRAY ANTENNA DEVICE HAVING IC UNITS WITH IF CONVERSION CIRCUITS FOR COUPLING ANTENNA ELEMENTS AND SIGNAL COMBINER

The present invention relates to an antenna device for use in reception or transmission of a microwave signal and, in particular, to an array antenna device which is useful for receiving broadcast through a satellite repeater.

In a known array antenna device, a plurality of antenna elements are arranged in a plane to form an antenna array. When those antenna elements receive a microwave signal, they produce received signals which are combined by a signal combining circuit to produce a combined signal. The combined signal is amplified at an amplifier to produce an amplified signal. The amplified signal is frequency-converted into an intermediate-frequency (IF) signal by an IF converting circuit which comprises a mixer, a local oscillator, and an IF amplifier.

However, the array antenna device has a degraded noise figure due to use of the signal combining circuit. This is because the signal combining circuit causes a combining loss. Moreover, the signal combining circuit makes a long coupling line between each of the antenna elements and the amplifier and therefore causes a transmission loss.

In another known array antenna device, a plurality of microwave integrated circuit units (MICUs) are used. Each of the MICUs comprises one of the antenna elements and an amplifier coupled thereto and is coupled to the signal combining circuit. Therefore, the received signals from the antenna elements are amplified at individual amplifiers to produce amplified signals which are combined by the signal combining circuit to produce a combined signal. The combined signal is applied to the IF conversion circuit.

In the other array antenna device, each of antenna elements and each of the amplifiers are disposed adjacent to each other. Therefore, a length of the coupling line between the antenna element and the amplifier is considerably reduced so that the transmission loss is reduced between the antenna element and the amplifier. However, the signal combining circuit is also used between the amplifiers and the IF conversion circuit and makes the transmission loss and the combining loss.

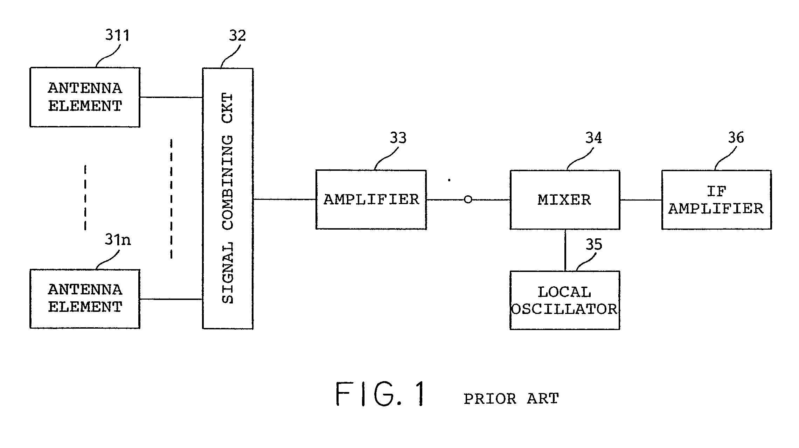

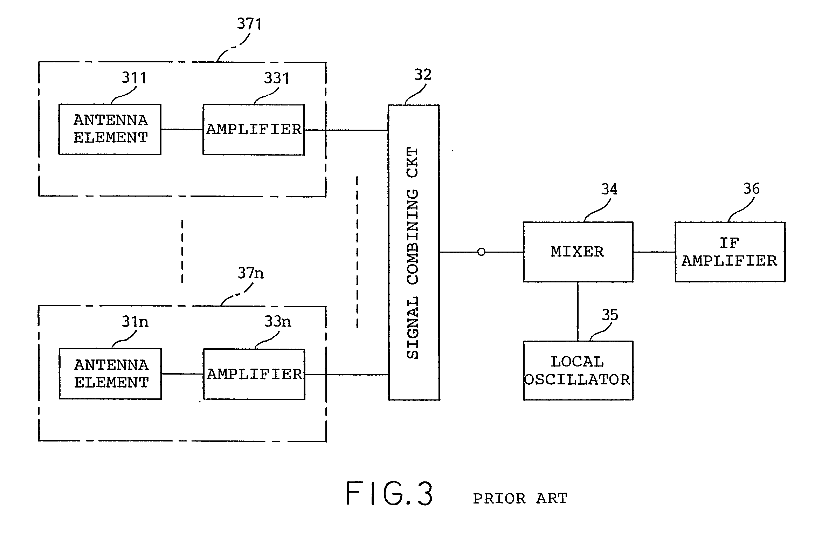

Generally, a direction of a main lobe of an array antenna can be changed by use of variable phase shifters in a coupling line for the antenna array. However, since the phase shifter causes a large transmission loss, it cannot be used in those array antenna devices shown in Fig. 1 and it is difficult to use the phase shifter in those any antenna devices shown in Fig. 3. Accordingly, it is necessary to move the array antenna device so as to direct the main lobe to the satellite repeater.

## Summary of the Invention:

It is an object of the present invention to provide an array antenna device with a reduced transmission loss between the each antenna element and the IF conversion circuit.

It is another object of the present invention to provide an array antenna device wherein variable phase shifters can be used for adjusting the direction of the main lobe of the array antenna.

According to the present invention, an array antenna device with a plurality of antenna elements comprises a plurality of integrated circuit units each of which comprises: at least one of the antenna elements for receiving a radio wave to deliver a receive signal; amplifier means coupled to the antenna element for amplifying the receive signal as an amplified signal; local oscillator means for oscillating a local signal of a predetermined frequency in synchronism with a reference signal; mixer means coupled to the amplifier means and the local oscillator means for mixing the amplified signal and the local signal to produce an intermediate frequency signal; and an output terminal coupled to the mixer means for delivering the intermediate frequency signal as an output signal. The antenna device further comprises combining means coupled to the output terminal of each of the integrated circuit units for combining the output signal from each of the integrated circuit units to produce a combined signal; an output port coupled to the combining means for delivering the combined signal; reference signal generating means for generating the reference signal; and coupling means for coupling the local oscillating means and the reference signal generating means for supplying the reference signal to the local oscillator means.

According to an aspect of the present invention, each of the integrated circuit units further comprises an intermediate frequency amplifier means connecting the mixer means and the output terminal for amplifying the intermediate frequency signal to deliver the intermediate frequency signal as amplified to the output terminal.

According to another aspect of the present invention, the antenna device further comprises a plurality of variable phase shifters each coupled between the output terminal and the combining means for shifting a phase of the output signal passing therethrough.

According to another aspect of the present invention, the reference signal generating means is connected to the conductive line whereby the combining means serves as the coupling means.

According to still another aspect of the present invention, the coupling means comprises signal distributing means connecting the reference signal generating means and each of the integrated circuit units at the input terminal.

According to yet another aspect of the present invention, the antenna device further comprises a case, a circuit board mounted in the case and having the plurality of integrated circuit units mounted thereon, the circuit board further having the combining means, the output port, the reference signal generating means, and coupling means formed thereon, and an electric connector mounted on the case and connected to the output port.

According to a further aspect of the present invention, each of the integrated circuit units comprises a reference signal receiving antenna, the reference signal generating means having a reference signal transmitting antenna so that the coupling means is consisted by antenna coupling between the reference signal receiving antenna and the reference signal transmitting antenna.

The present invention is also applicable to an array antenna device for radiating a radio wave. That is, each of the antenna element is formed in an integrated circuit unit together with a distributing means for distributing a signal to be transmitted, an integrated circuit chip comprising a frequency conversion circuit means for frequency-converting the signal to produce a converted signal and a power amplifier for amplifying the converted signal to excite the antenna element, and a reference signal generating means for synchronizing the frequency conversion circuit means with one another.

Brief Description of the Drawings:

Fig. 1 is a block diagram view of a known array antenna device;

Figs. 2A to 2D are plan views of different antenna elements:

Fig. 3 is a block diagram view of another known array antenna device;

Fig. 4 is a block diagram view of an array antenna device according to a first embodiment of the present invention;

Fig. 5A is a perspective view of a microwave integrated circuit unit (MICU) used in the first embodiment of Fig. 3;

Fig. 5B is a sectional view of the MICU of Fig. 5A;

Fig. 6 is a plan view of the array antenna device of Fig. 3 with a cover plate being removed;

Fig. 6A is a plan view illustrating a circuit structure of a reference signal generator shown by a block of chain line in Fig. 6;

Fig. 7 is a block diagram view of another MICU;

Fig. 8 is a block diagram view of an array antenna device according to a second embodiment using the MICU of Fig. 7;

Fig. 9 is a plan view of the array antenna device of Fig. 8 with a cover plate being removed;

Figs. 9A and 9B are plan views illustrating circuit structures of a reference signal generator and a band stop filter shown by boxes of chain lines in Fig. 9;

Fig. 10 is a block diagram view of an array antenna device according to a third embodiment using the MICU of Fig. 7:

Fig. 11 is a plan view of the array antenna device of Fig. 10 with a cover plate being removed;

Fig. 11A is a plan view illustrating a circuit structure of a reference signal generator shown by a block of chain line in Fig. 11;

Fig. 12 is a block diagram view of an array antenna device according to a fourth embodiment using the MICU of Fig. 7:

Fig. 13 is a block diagram view of an array antenna device according to a fifth embodiment;

Fig. 14 is a plan view of the antenna device of Fig. 13 with a cover plate being removed;

Fig. 15 is a block diagram view of an array antenna device according to a sixth embodiment;

Fig. 16 is a block diagram view of an array antenna device according to a seventh embodiment;

Fig. 17 is a block diagram view of another MICU;

Fig. 18 is a block diagram view of an array antenna device according to an eighth embodiment using the MICU of Fig. 17;

Fig. 19 is a block diagram view of an array antenna device according to a ninth embodiment using the MICU of Fig. 17;

Fig. 20 is a block diagram view of an array antenna device according to a tenth embodiment;

Fig. 21 is a plan view of the antenna device of Fig. 20 with a cover plate being removed;

Fig. 22 is a block diagram view of an array antenna device according to an eleventh embodiment;

Fig. 23 is a plan view of the antenna device of Fig. 22; and

Fig. 24 is a block diagram view of an array antenna device according to a twelfth embodiment.

Description of Preferred Embodiments:

Prior to description of preferred embodiments of the present invention, known array antenna devices will be described below with reference to Figs. 1, 2A-2D, and 3 in order to help the better understanding of the present invention.

Referring to Fig. 1, a known array antenna device shown therein comprises a plurality of antenna elements 311 through 31n (n being natural number) for receiving a radio wave of, for example, 40 GHz band to produce receive signals, a signal combining circuit 32 coupled to the plurality of antenna elements for combining the receive signals to produce a combined signal, and an amplifier 33 coupled to the signal combining circuit for amplifying the combined signal to produce an amplified signal.

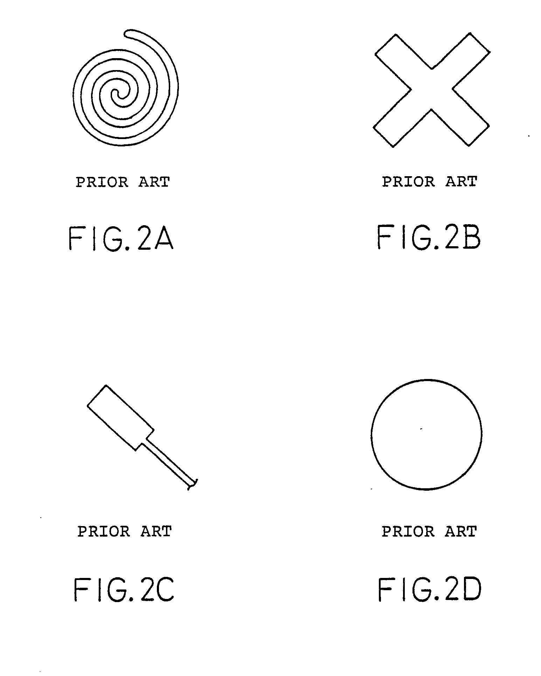

Each of the antenna elements 311 through 31n is one of a spiral type shown in Fig. 2A, a cross dipole type shown in Fig. 2B, a 1 4 wavelength open-ended line type shown in Fig. 2C, and a batch type shown in Fig. 2D. The used type is determined by, for example, polarization of the radio wave. The antenna elements 311 through 31n, the signal combining circuit 32 and the amplifier 33 are formed and mounted on a circuit substrate (not shown) which is connected to a mixer 34 by an electric connector (not shown).

The amplified signal is mixed at the mixer 34 with a local signal from a local oscillator 35 to produce an intermediate frequency (IF) signal of, for example, 1 GHZ. The IF signal is amplified at an IF amplifier 36.

Referring to Fig. 3, another known array antenna device shown therein is similar to the device of Fig. 1 except that a plurality of amplifiers 331 through 33n are coupled with the plurality of antenna elements 311 through 31n to form a plurality of microwave integrated circuit units (MICUs) 371 through 37n, respectively, which are coupled with the signal combining circuit 32. In this arrangement, the receive signals from the antenna elements 311 through 31n are amplified at individual amplifiers 331 through 33n to produce a plurality of amplified signals which are combined at the signal combining circuit 32 to produce a combined signal. The combined signal is applied to the mixer 34 and frequency converted into the IF signal.

The signal combining circuit 32 causes the combining loss and the transmission loss. Therefore, those known array antenna devices have the problems as described in the preamble.

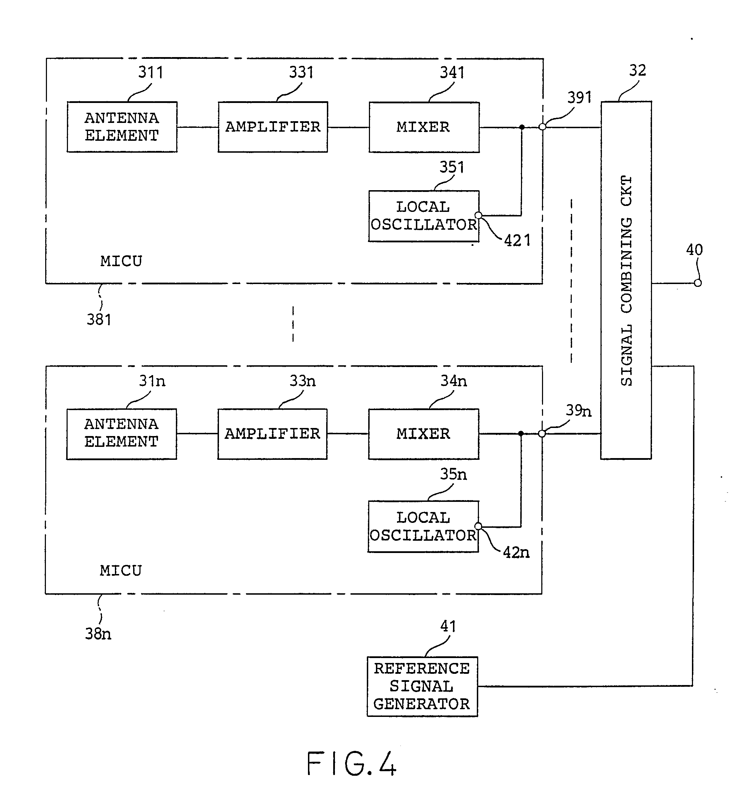

Referring to Fig. 4, the array antenna device according to the first embodiment of the present invention comprises a plurality of MICUs 381 through 38n wherein the plurality of amplifiers 331 through 33n, a plurality of mixers 341 through 34n and a plurality of local oscillators 351 through 35n are formed together with the plurality of antenna elements 311 through 31n, respectively, by the way of the integrated circuit technique. These MICUs 381 through 38n have output terminals 391 through 39n which are coupled with the signal combining circuit 32. The signal combining circuit 32 is connected to an output port 40.

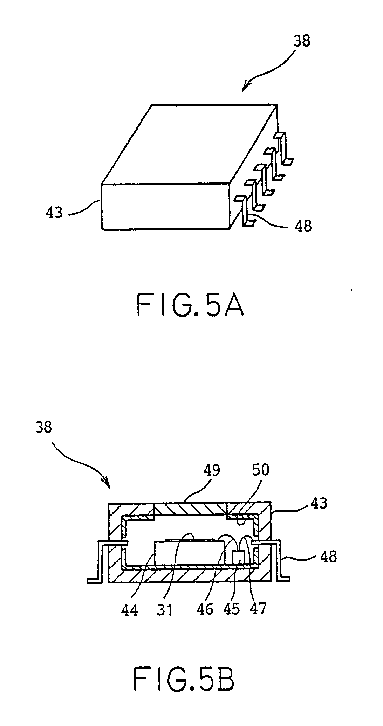

Referring to Figs. 5A and 5B, each of the MICUs is shown at 38 and comprises a case 43 in which a substrate 44 and an IC chip 45 are encapsulated. The substrate 44 is made of, for example, alumina ceramic and has the antenna element 31 formed thereon in one of types shown in Figs. 2A-2D by a thin-film circuit forming technique. The IC chip 45 has the amplifier 33, the mixer 34 and the local oscillator 42 formed therein. Bonding wires 46 and 47 connect the antenna element 31, the IC chip 45 and terminal plates 48 which are fixedly mounted in the case 43 and extended outside the case 43. The case 43 has a radio wave transmission window 49 which is formed of, for example, glass, ceramics, plastics, or the like at a position facing the antenna element 31. The case 43 has an inner surface which is partially coated with a metallic film 50 formed by metallizing technique except the window 49. The metallic film 50 is for protection of the IC chip 45 against the electromagnetic interference and the ultraviolet ray. It is of course that the metallic film 50 is formed to be insulated from the terminal plates 48. One of the terminal plates is corresponding to the output terminal 39.

When the substrate 44 is made of a semiconductor such as silicon or gallium arsenide, the amplifier 33, mixer 34 and the local oscillator 35 can also be formed in the substrate 29 without use of the IC chip 45 different from the substrate 29. In the case, the bonding wire 46 can be omitted.

Thus, the amplifier 33 is disposed adjacent the antenna element 31 and the IF conversion circuit comprising the mixer 34 and the local oscillator 42. Therefore, lengths of lines for coupling therebetween are small so that transmission loss is very reduced.

Returning to Fig. 4, the antenna device further comprises a reference signal generator 41 electrically coupled to the local oscillators 421 through 42n for generating a reference signal to synchronize the local signals from the local oscillators 421 through 42n with each other. In the shown embodiment, the electrical coupling is established by the signal combining circuit 32. That is, the reference signal generator 41 is connected with the signal combining circuit 32. The local oscillators 351 through 35n have reference signal input terminals 421 through 42n which are connected to the individual output terminals 391 through 39n. Therefore, the reference signal from the reference signal generating circuit 41 is delivered to the local oscillators 351 through 35n through the signal combining circuit 32, the output terminals 391 through 39n and the reference signal input terminals 421 through 42n.

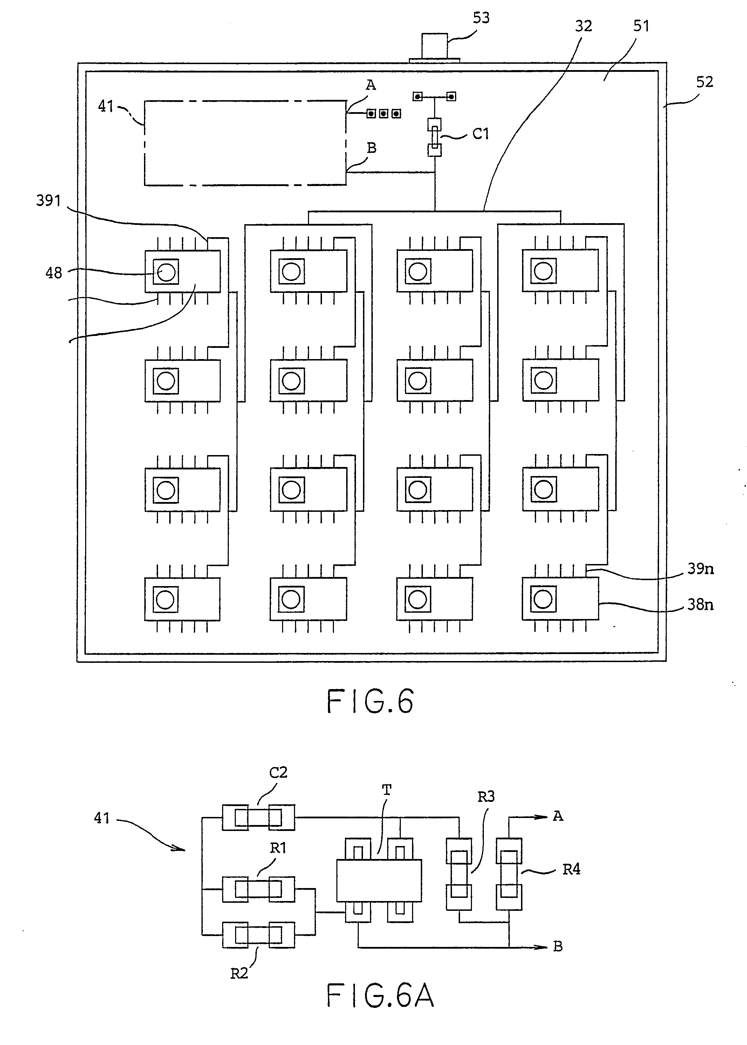

Referring to Fig. 6, an example of the array antenna device of Fig. 4 shown therein comprises a circuit board 51 on which sixteen (16) MICUs 381 through 38n (n = 16), the reference signal generator 41 and signal combining circuit 32 are mounted. The circuit board 51 is fixed in a housing 52 which has an electrical connector 53 corresponding to the output port 40. The signal combining circuit 32 comprises strip lines extending on the circuit board 51 shown in the figure and connecting the MICUs 381 through 38n to the connector 53 through a chip capacitor C1. The reference signal generator 41 is also connected to the MICUs 381 through 38n through the strip lines. The reference signal generator 41 is shown by a box of a chain line in the figure for the purpose of simplification of the drawings but is shown in Fig. 6A in detail.

Referring to Fig. 6A, the reference signal generator 41 comprises a transistor T, a chip capacitor C2, and four (4) chip resistors R1 through R4 shown therein. The terminals A and B are connected to A and B in Fig. 6.

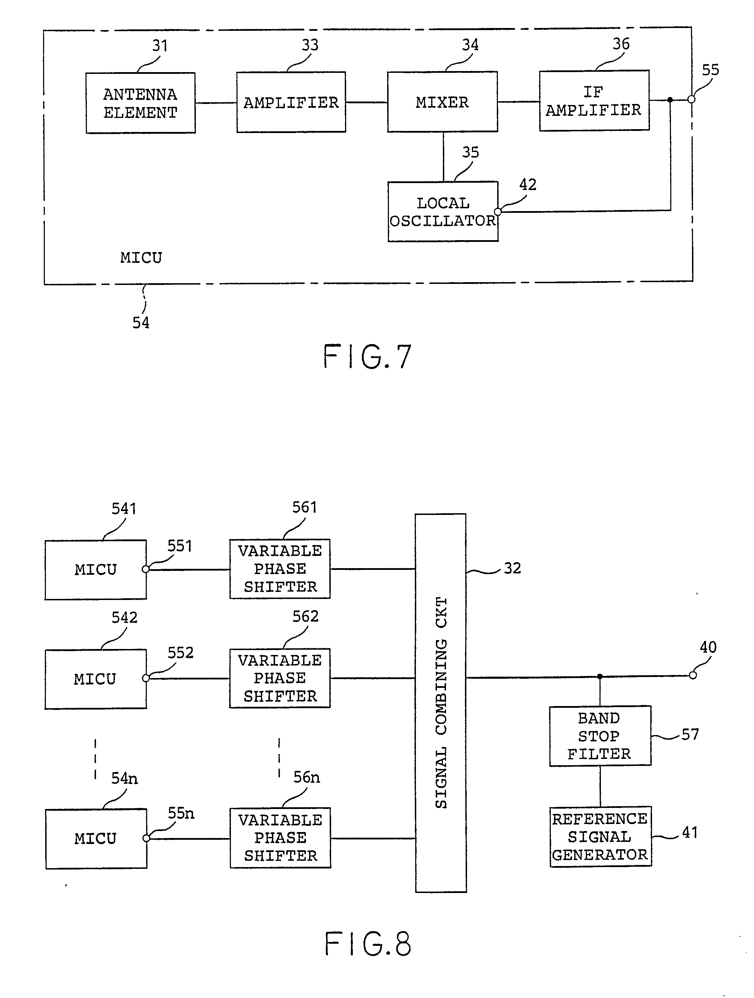

Referring to Fig. 7, another MICU 54 shown therein comprises the antenna element 31, the amplifier 33, the mixer 34 and the local oscillator 35 similar to the MICU 38 in Fig. 4 but further comprises the IF amplifier 36. The IF amplifier 36 is connected to an output terminal 55 of the MICU and the reference signal terminal 42 of the local oscillator 35 is also connected to the output terminal 55.

In the arrangement, the IF signal from the mixer 34 is amplified at the IF amplifier 36 and is provided to the output terminal 55 as an amplified IF signal.

The MICU 54 is also realized to have a structure similar to that of Figs. 5A and 5B. In that case, the IC chip comprises not only the amplifier, the mixer and the local oscillator but also the IF amplifier.

The MICU 54 can be substituted for each of MICUs 381 through 38n in Fig. 4.

Referring to Fig. 8, the shown array antenna device according to the second embodiment is similar to that of Fig. 4 but uses a plurality of MICUs of Fig. 7 as shown at 541 through 54n in place of MICUs 381 through 38n, a plurality of variable phase shifters 561 through 56n connected to the MICUs and a band stop filter 57.

The amplified IF signals from MICUs 541 through 54n, after passing through the variable phase shifters 561 through 56n, are combined by the signal combining circuit 32 and are provided to the output port 40 as a combined signal.

A direction of the main lobe of the array antenna is adjusted by adjusting the variable phase shifters 561 through 56n.

The band stop filter 57 is for preventing the combined signal from applying to the reference signal generator 41.

In Fig. 8, MICUs 541 through 54n can be replaced by MICUs 381 through 38n in Fig. 4.

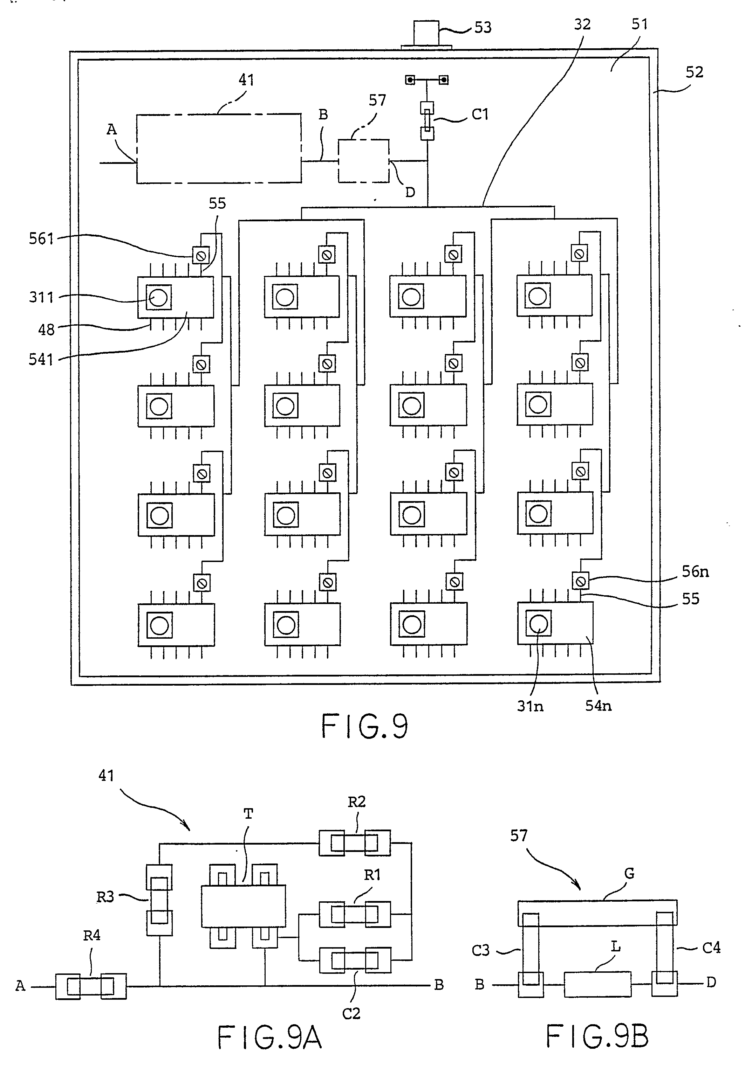

The array antenna device of Fig. 8 can be realized with a structure as shown in Figs. 9, 9A and 9B.

Referring to Fig. 9, the MICUs 541 through 54n, the variable phase shifters 561 through 56n (n = 16 in the shown embodiment), the band stop filter 57 and the signal reference generator 41 are disposed on the circuit board 51 as shown in Fig. 6. The shown structure is similar to that in Fig. 6 except that the band stop filter 57 and variable phase shifters 561 through 56n are used and that the MICU of Fig. 7 is used in place of each of the MICUs in Fig. 6.

In Fig. 9, the reference signal generator 41 and band stop filter 57 are shown by boxes of chain lines. But, they are shown in Figs. 9A and 9B in detail, respectively. The reference signal generator 41 in Fig. 9A is equivalent of that in Fig. 6A but is only different in disposition of the circuit elements T, C2, and R1 through R4.

Referring to Fig. 9B, the band stop filter 57 comprises a ground potential strip line G, two capacitors C3 and C4, and an inductor L.

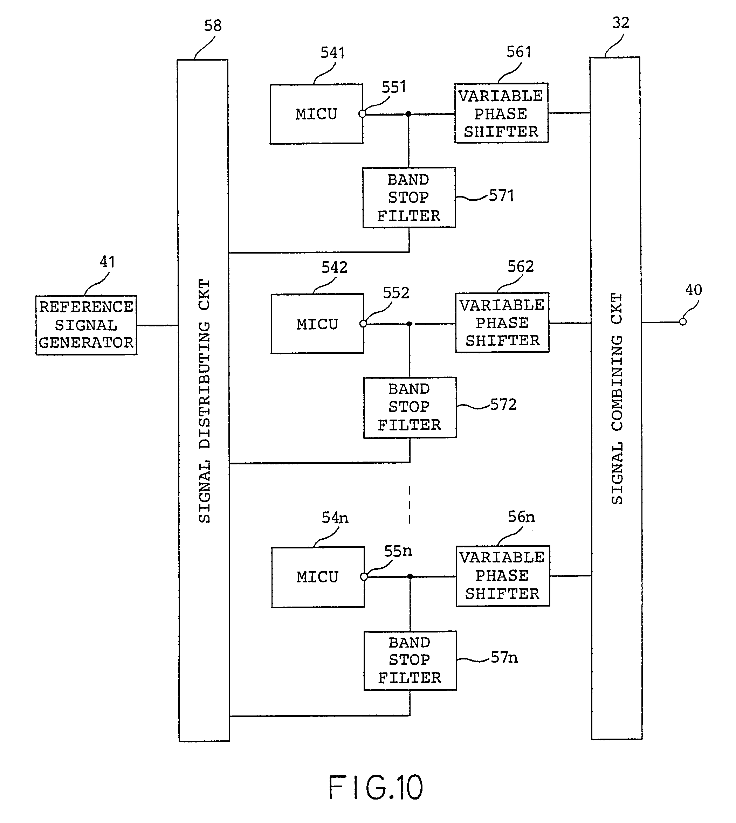

Referring to Fig. 10, the array antenna device according to the third embodiment shown therein is a modification of the array antenna device of Fig. 8. In this modification, the reference signal generator 41 is coupled to the output terminals 551 through 55n of the MICUs 541 through 54n through not the signal combining circuit 32 but a signal distributing circuit 58 and band stop filters 571 through 57n. Therefore, the reference signal from the reference signal generator 41 is applied to the local oscillators (35 in Fig. 7) in the MICUs 541 trough 54n through the signal distributing circuit 58 and band stop filters 571 through 57n.

The array antenna device of Fig. 10 is realized similar to that shown in Figs. 9, 9A and 9B.

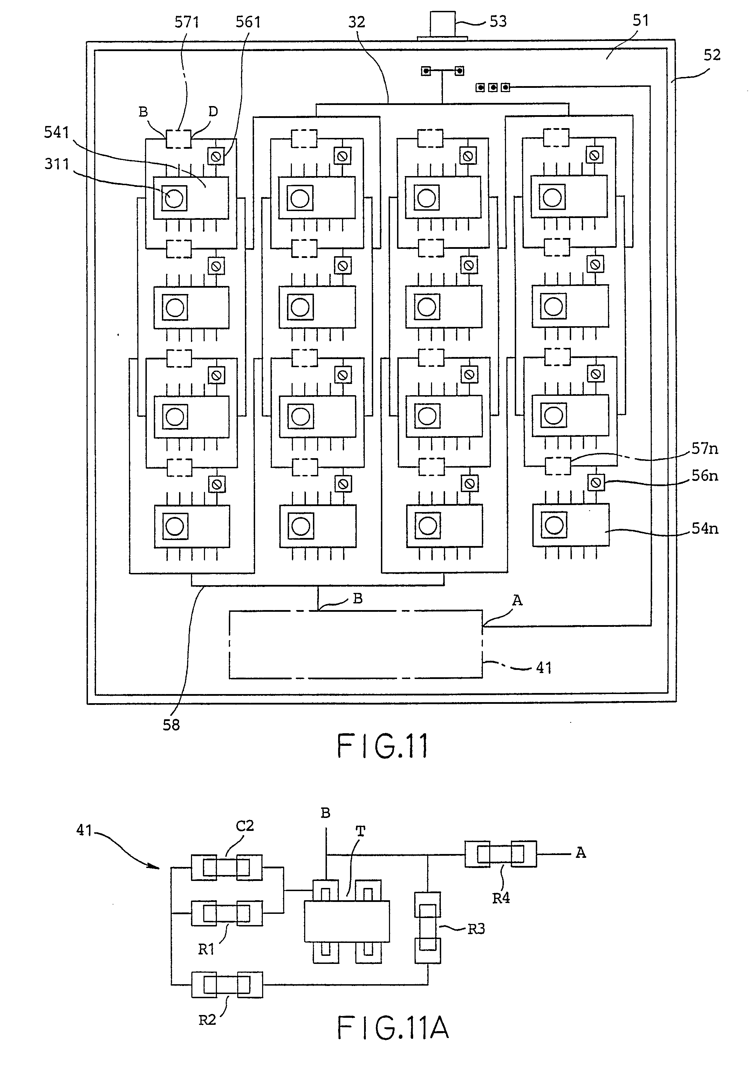

Referring to Figs. 11 and 11A, the MICUs 541 through 54n, the variable phase shifters 561 through 56n, the band stop filters 571 through 57n (n = 16 in the shown embodiment) and the signal reference generator 41 are disposed on the circuit board 51 as shown in Fig. 11. The signal combining circuit 32 and the variable phase shifters 561 through 56n are formed similar to those in Fig. 9. The signal distributing circuit 58 comprises micro strip lines and connects the reference signal generator 41 and the MICUs 541 through 54n through band stop filters 571 through 57n.

In the figure, the band stop filters 571 through 57n are shown by boxes of chain lines but can have a circuit structure similar to that shown in Fig. 9B. The reference signal generator 41 is also shown by a box of a chain line but has a circuit structure sown in Fig. 11A. The circuit of Fig. 11A is equivalent to that of Fig. 9A but is only different from it in disposition of the circuit elements T, C2, and R1 through R4.

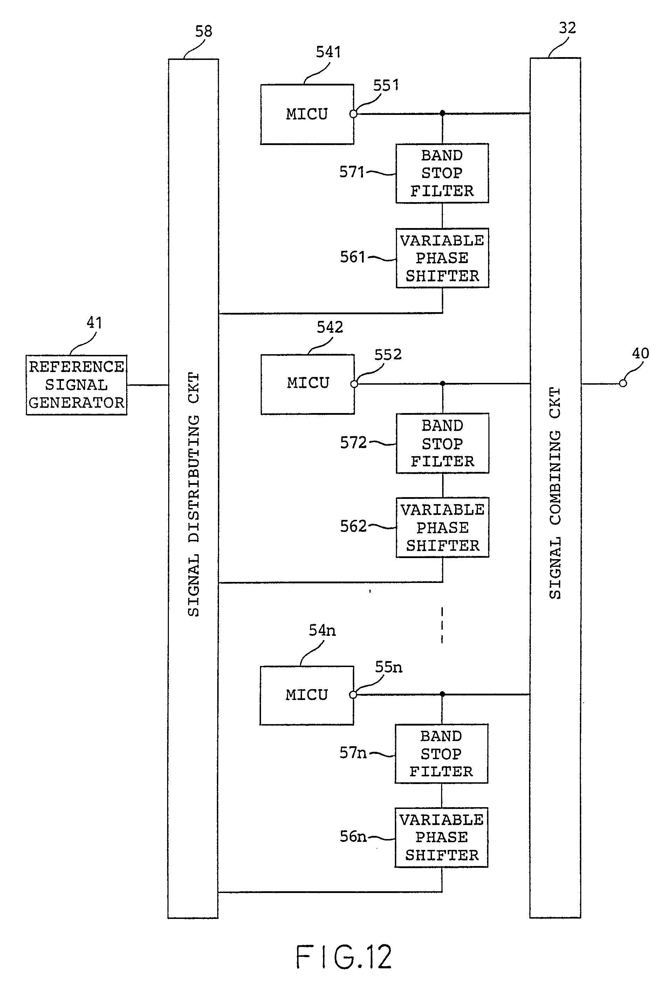

Referring to Fig. 12, the array antenna device according to the fourth embodiment shown therein is a modification of the array antenna device of Fig. 10. That is, the variable phase shifters 561 through 56n are disposed to connect the signal distributing circuit 58 and the band stop filters 561 through 56n. It will be understood that the array antenna device is also realized similar to that of Fig. 11 with the difference of disposition of the variable phase shifters 561 through 56n.

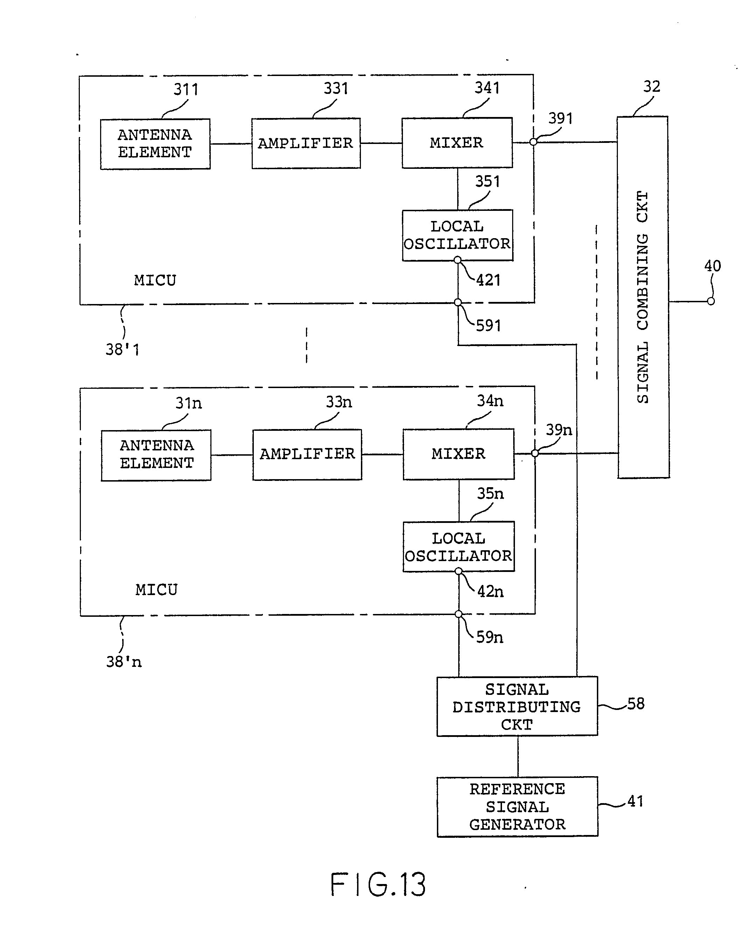

Referring to Fig. 13, the array antenna device according to the fifth embodiment shown therein is a modification of the device of Fig. 4. Each of MICUs used therein is only different from each of MICUs 381 through 38n in Fig. 4 in that it has an input terminal connected to the reference signal input terminal 42 of the local oscillator 35. The reference signal input terminal 42 is not connected to the output terminal 39. Therefore, the MICUs in this embodiment are represented by the same reference numeral with a prime ($'$), that is, $38'1$ through $38'n$. The input terminals are represented by 591 through 59n.

It will be understood that each of MICUs $38'1$ through $38'n$ can be formed with a structure similar to that of Figs. 5A and 5B. Another of the terminal plates 48 is connected to the local oscillator in the IC chip 45 and is corresponding to the input terminal 59.

The reference signal generator 41 is connected to the input terminals 591 through 59n of MICUs $38'1$ through $38'n$.

It will be understood that the array antenna device can be realized on a circuit board similar to Fig. 6.

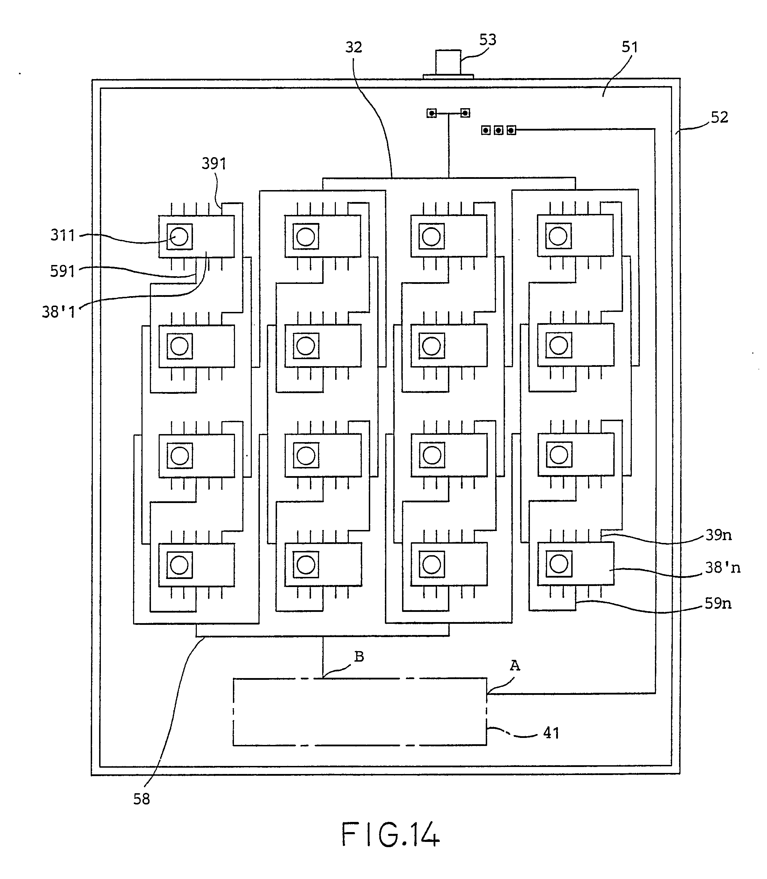

Referring to Fig. 14, the MICUs $38'1$ through $38'n$ and the signal combining circuit 32 are formed on the circuit board 51 similar to that of Fig. 6. The signal distributing circuit 38 is formed on the circuit board 51 to connect the reference signal generator 41 and terminal plates corresponding to the input terminals 591 through 59n of MICUs $38'1$ through $38'n$.

The reference signal generator 41 is formed similar to that of Fig. 11A. It should be appreciated that the terminals A and B in Fig. 11A are connected to terminals A and B in Fig. 14.

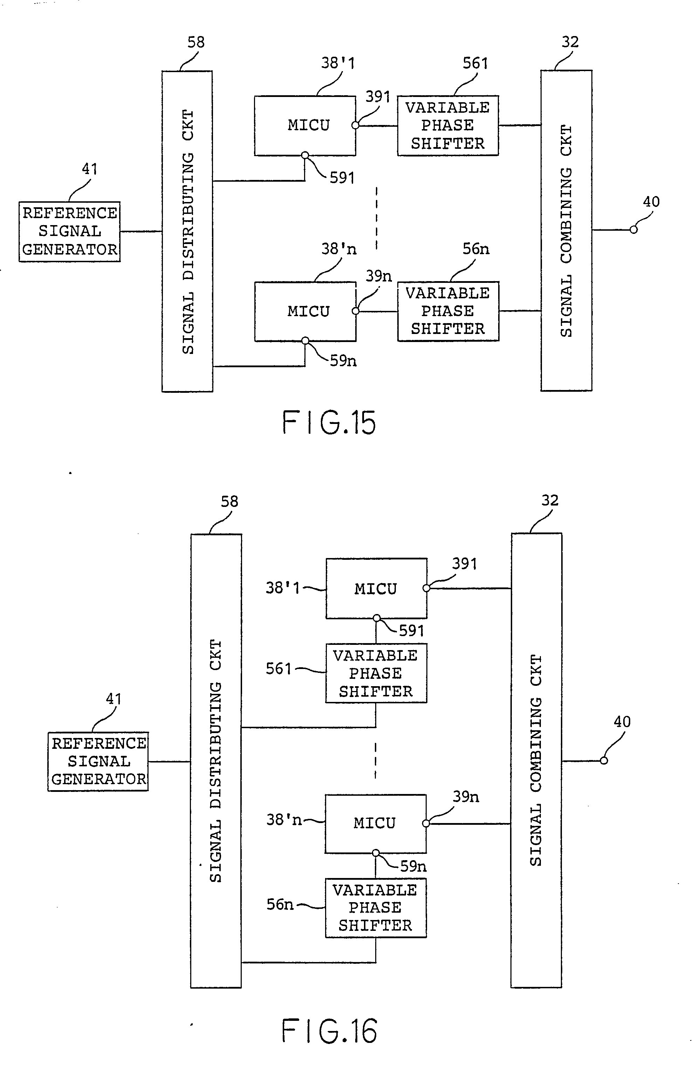

Referring to Fig. 15, the array antenna device according to the fifth embodiment is a modification of the array antenna device of Fig. 13 by use of variable phase shifters 561 through 56n in the lines connecting the output terminals 391 through 39n and the signal distributing circuit 32. Thus, a direction of the main lobe of the antenna array can be adjusted by adjusting the variable phase shifters 561 through 56n.

The array antenna device can be realized on the circuit board 51 in Fig. 14 by disposing the variable phase shifters 561 through 56n at positions similar to those in Fig. 9.

Referring to Fig. 16, the shown array antenna device according to the seventh embodiment is a modification of Fig. 15 by displacing the variable phase shifters 561 through 56n in the lines connecting the signal distributing circuit 58 and the input terminals 591 through 59n of the MICUs $38'1$ through $38'n$.

The array antenna device is also realized on the circuit board 51 in Fig. 14 by disposing the variable phase shifters 561 through 56n in the lines connecting the signal distributing circuit 58 and the input terminals 591 through 59n of the MICUs $38'1$ through $38'n$.

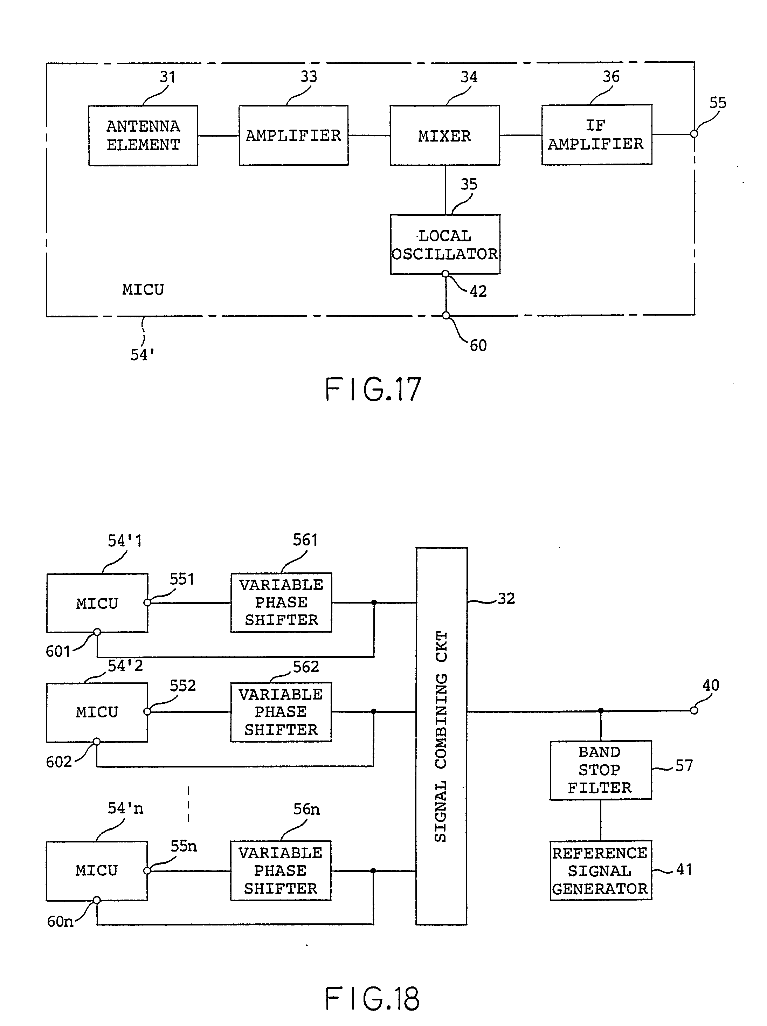

Referring to Fig. 17, another MICU shown therein is similar to the MICU 54 of Fig. 7 but has an input terminal connected to the reference signal input terminal 42 of the local oscillator 35. The reference signal input terminal 42 is not connected to the output terminal 55. Therefore, the MICU of the figure is represented by the same numeral 54 with a prime ($'$) and the input terminal is represented by 60. The MICU $54'$ is also similar to the MICU in Fig. 13 except the IF amplifier 36.

This MICU $54'$ can be used in place of MICU $38'$ in the devices of Figs. 13, 15 and 16.

The MICU $54'$ is also formed to have a structure similar to that shown in Figs. 5A and 5B by forming the IF amplifier 36 in the IC chip 45 while the local oscillator 35 being connected to another of terminal plates 48 which is corresponding to the input terminal 60.

Referring to Fig. 18, the eighth embodiment shown therein uses a plurality of MICUs of Fig. 17 which are represented at $54'1$ through $54'n$. The array antenna device of the figure is similar to that of Fig. 8 except that the reference signal is applied to the MICUs through the input terminals 601 through 60n bypassing the variable phase shifters 561 through 56n and the output terminals of the MICUs, respectively.

The array antenna device can be realized on the circuit board 51 in Fig. 9 by replacing the MICUs 541 through 54n by the MICUs $54'1$ through $54'n$ and by forming additional micro strip lines to connect the micro strip lines of the signal combining circuit 32 to the terminal plates of MICUs $54'1$ and $54'n$ corresponding to the input terminals 601 through 60n.

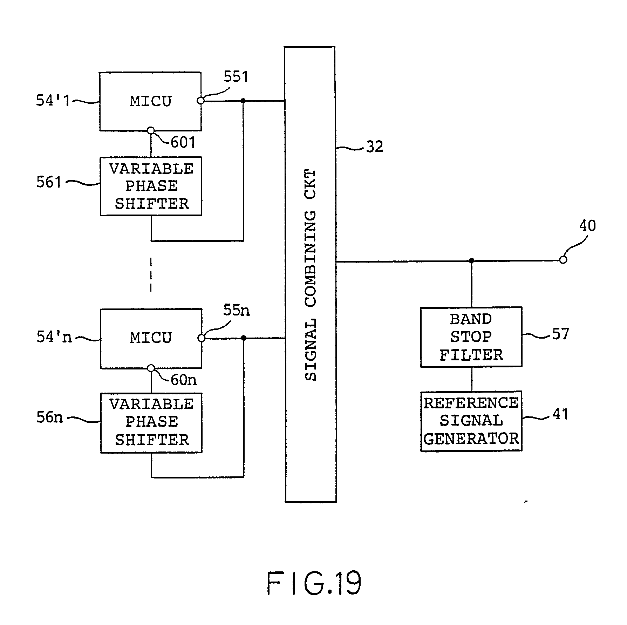

Referring to Fig. 19, the shown ninth embodiment is a modification of the array antenna device of Fig. 18. That is, the output terminals 551 through 55n of MICUs 54'1 through 54'n are directly connected to the signal combining circuit 32 while the input terminals 601 through 60n are connected to the signal combining circuit 32 through the variable phase shifters 561 56n.

It will be understood that the array antenna device of Fig. 19 can be also formed on the circuit board by modifying formation of Fig. 9.

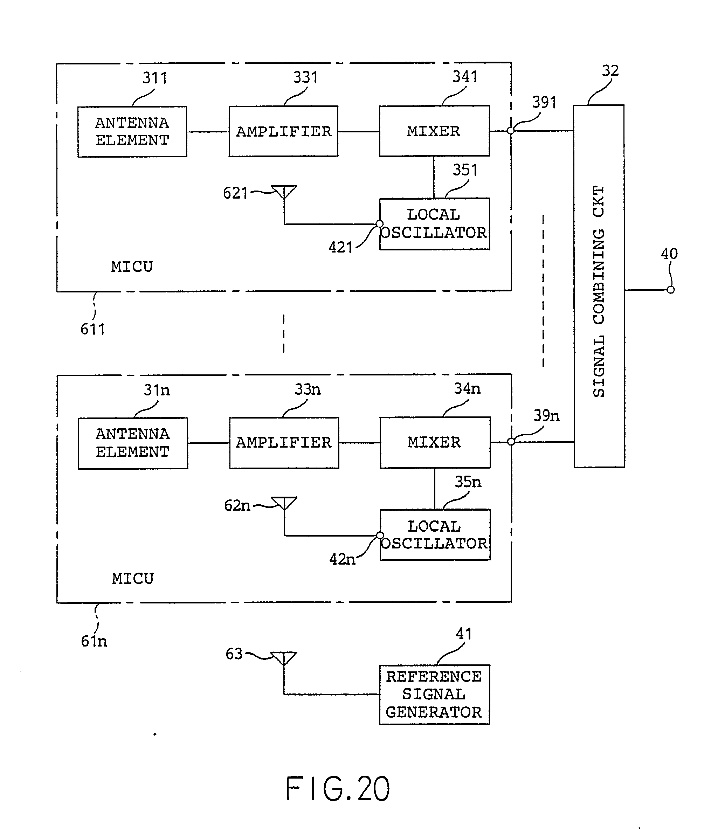

Referring to Fig. 20, the tenth embodiment shown therein is characterized in that wireless coupling is made between the local oscillator in the MICU and the reference signal generator by use of antennas, but is similar to the array antenna device of Fig. 4 in the other circuit formation. That is, MICUs 611 through 61n shown in the figure are similar to MICUs 381 through 38n in Fig. 4 except reference signal receiving antennas 621 which are connected to the reference signal input terminals 421 through 42n of the local oscillators 351 through 35n. The reference signal input terminals 421 through 42n are not connected to the output terminals 391 through 39n.

The reference signal receiving antennas 621 through 62n can be made as strip lines on the IC chips (45 in Fig. 5B).

The reference signal generator 41 is also provided with a reference signal transmitting antenna 63.

Therefore, the reference signal is radiated from the reference signal transmitting antenna 63 and is received at the reference signal receiving antennas 621 through 62n in the MICUs 611 through 61n. Accordingly, the local oscillators 351 through 35n are synchronized with one another.

In Fig. 20, each of the MICUs 611 through 61n can be provided with IF amplifiers between the mixer 34 and the output terminal 39 as shown in Fig. 7.

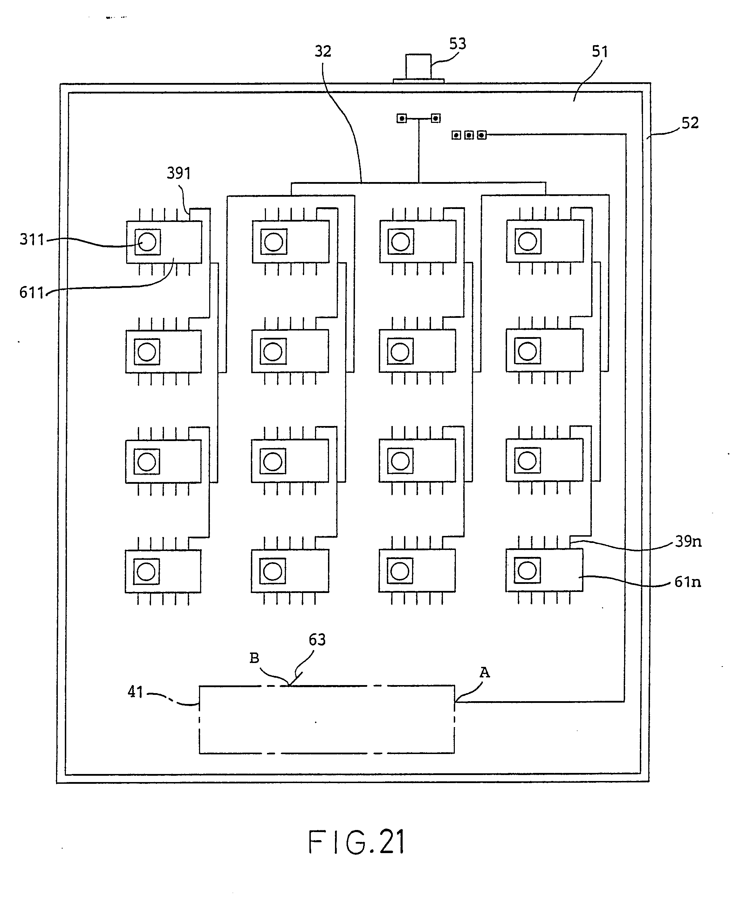

Referring to Fig. 21, the array antenna device of Fig. 20 is also formed on the circuit board 51 in the similar way as in Fig. 6. The MICUs 611 through 61n, the signal combining circuit 32 and the reference signal generator 41 are formed on the circuit board 51. The reference signal transmitting antenna 63 is formed as a strip line on the circuit board 51.

The reference signal generator 41 is shown as a box of a chain line but has the circuit structure of Fig. 11A. Terminals A and B in Fig. 11A should be connected to terminals A and B in Fig. 21.

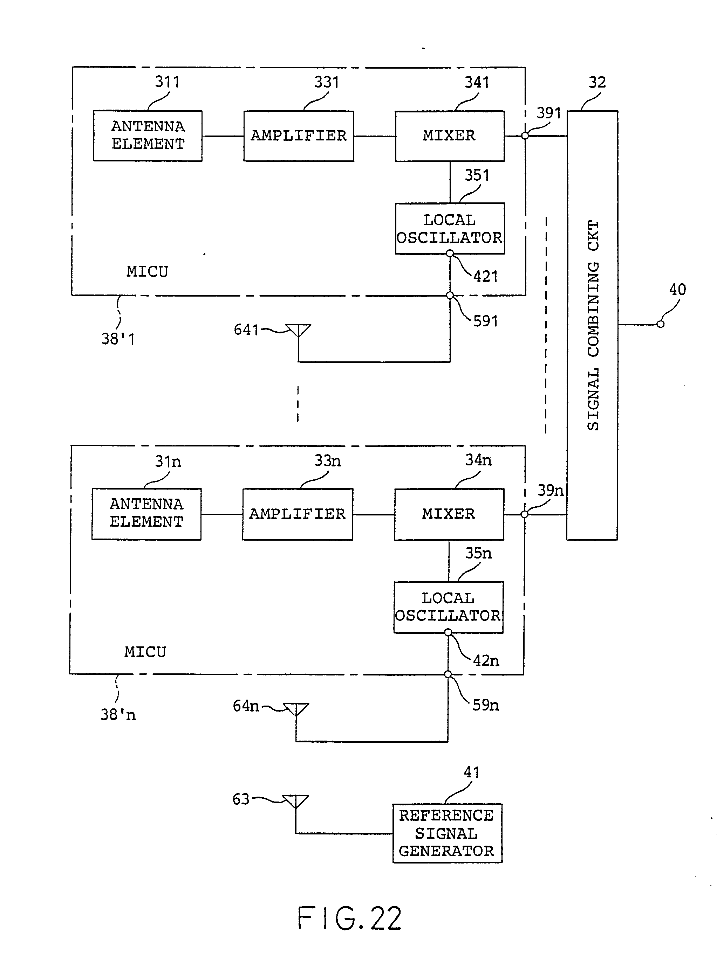

Referring to Fig. 22, the eleventh embodiment shown therein is a modification of the embodiment of Fig. 20 by using MICUs 38'1 through 38'n of Fig. 13 and by forming the reference signal receiving antennas outside the MICUs as shown at 641 through 64n.

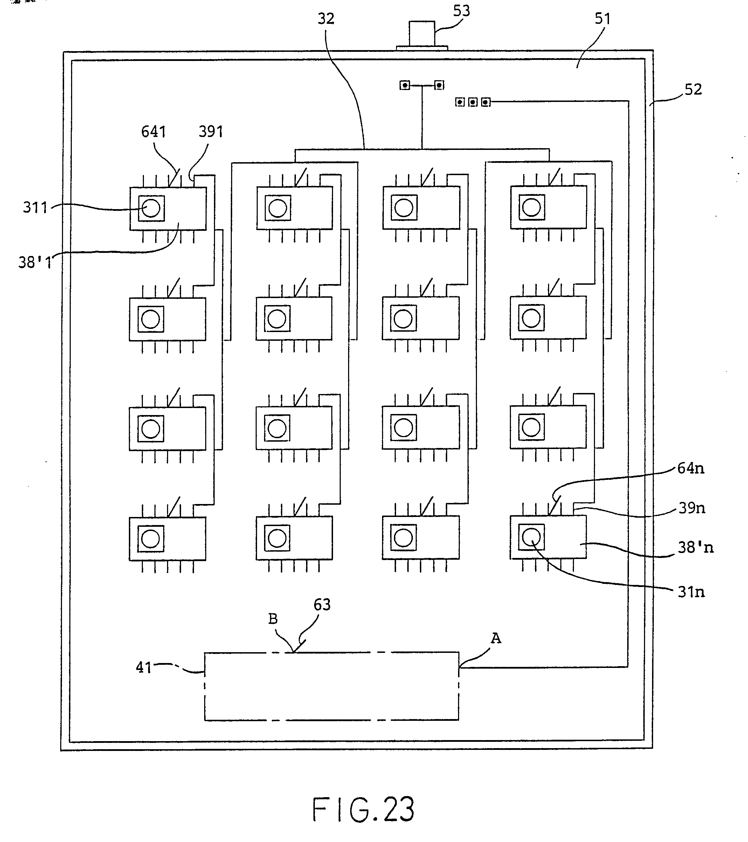

Therefore, the array antenna device of Fig. 22 can be realized as shown in Fig. 23 with an arrangement similar to that shown in Fig. 21.

Referring to Fig. 23, the MICUs 38'1 through 38'n are used in place of the MICUs 611 through 61n. The reference signal antennas 641 through 64n are formed as micro strip lines on the circuit board and are connected to terminal plates of MICUs corresponding to the reference signal input terminals 591 through 59n.

The reference signal generator 41 shown by a box of a chain line has the circuit structure shown in Fig. 11A. The terminals A and B in Fig. 11A should be connected to terminals A and B in Fig. 23.

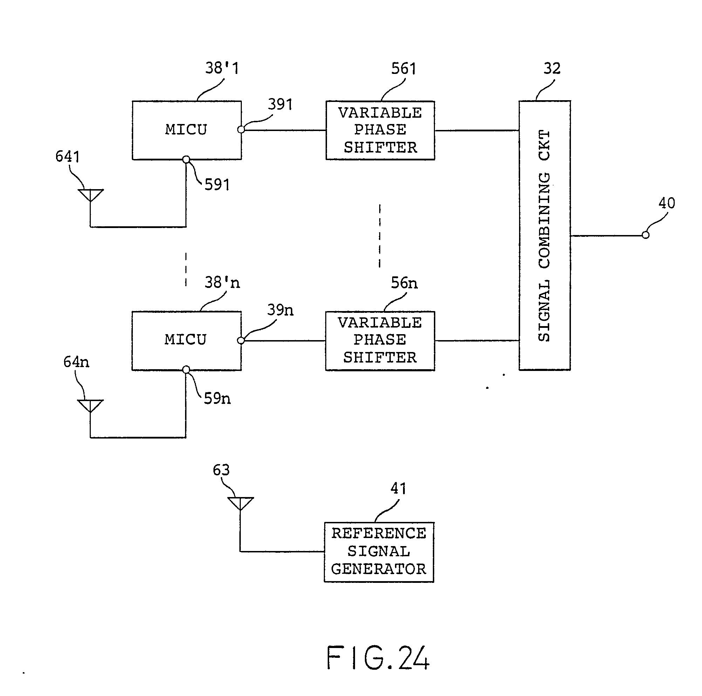

Referring to Fig. 24, the shown twelfth embodiment is a modification of the embodiment of Fig. 22 by using variable phase shifters 561 through 56n in the lines connecting the output terminals 391 through 39n of the MICUs 38'1 through 38'n and the signal combining circuit 32.

The array antenna device of Fig. 24 can also be realized in a structure similar to that of Fig. 23 but the variable phase shifters 561 through 56n are provided on the circuit board 51 as shown in Fig. 9.

In Figs. 22 and 24, the MICU 54' of Fig. 17 can be used in place of each of the MICUs 38'1 through 38'n.

The present invention has been described in connection with various embodiments of an array antenna device for receiving a radio wave, but it is applicable to an array antenna device for radiating a radio wave. That is, a radiating antenna device is realized by replacing the amplifier 331, the output terminal 39 and 55, the signal combining circuit 32, and output port 40 by a power amplifier, an input terminal, a signal distributing circuit and an input port, respectively. In a resultant device, for example, in Fig. 4, an IF signal to be transmitted is applied to the input port (40) and is distributed to each of MICUs 381 through 38n. The signal is mixed at the mixer (34) with the local signal from the local oscillator (42) to produce a frequency converted signal. The frequency converted signal is power-amplified at the power amplifier (33) to produce a transmission signal which is applied to the antenna element (31). Thus, the transmission signal is radiated from the antenna element as a radio wave. In that case, a direction of the main lobe of the antenna array is also adjusted by use of variable phase shifters as shown in, for example, Fig. 8.

## Claims

1. An antenna device having a plurality of antenna elements for receiving a radio wave which comprises:

a plurality of integrated circuit units each com-
prising:

one of said antenna elements for receiving the
radio wave to deliver a receive signal;

amplifier means coupled to said antenna element
for amplifying said receive signal as an amplified
signal;

local oscillator means for oscillating a local signal
of a predetermined frequency in synchronism with
a reference signal;

mixer means coupled to said amplifier means and
said local oscillator means for mixing said amplified
signal and said local signal to produce an intermediate frequency signal; and

an output terminal coupled to said mixer means for
delivering said intermediate frequency signal as an
output signal;

combining means coupled to said output terminal
of each of said integrated circuit units for combining said output signal from each of said integrated
circuit units to produce a combined signal;

an output port coupled to said combining means
for delivering said combined signal;

reference signal generating means for generating
said reference signal; and

coupling means for coupling said local oscillating
means and said reference signal generating means
for supplying said reference signal to said local
oscillator means.

2. An antenna device as claimed in Claim 1,
wherein each of said integrated circuit units further
comprises an intermediate frequency amplifier
means connecting said mixer means and said output terminal for amplifying said intermediate frequency signal to deliver said intermediate frequency signal as amplified to said output terminal.

3. An antenna device as claimed in Claim 1 or
2,
which further comprises a plurality of variable
phase shifters each coupled between said output
terminal and said combining means for shifting a
phase of said output signal passing therethrough.

4. An antenna device as claimed in any one of
Claims 1 to 3,
wherein said local oscillator means has a reference
signal input terminal which is connected to said
output terminal.

5. An antenna device as claimed in Claim 4,
wherein said combining means comprises a conductive line which is connected in common to each
of said integrated circuit units at said output terminal.

6. An antenna device as claimed in Claim 5,
wherein said reference signal generating means is
connected to said conductive line whereby said
combining means serves as said coupling means.

7. An antenna device as claimed in Claim 6,

which further comprises a filter means connecting
said reference signal generating means and said
conductive line so as to prevent said combined
signal from entering said reference signal generating means.

8. An antenna device as claimed in Claim 7,
which further comprises a plurality of variable
phase shifters each coupled between said output
terminal and said conductive line for shifting a
phase of said output signal passing therethrough.

9. An antenna device as claimed in any one of
Claims 5 to 8,
wherein said coupling means comprises signal distributing means coupled to said reference signal
generating means and each of said integrated circuit units at said output terminal.

10. An antenna device as claimed in Claim 9,
wherein said coupling means comprises a plurality
of filter means each connecting said signal distributing means and each of said integrated circuit
units at said output terminal so as to prevent said
combined signal from entering said reference signal generating means through said signal distributing means.

11. An antenna device as claimed in Claim 10,
wherein said coupling means comprises a plurality
of variable phase shifters each connecting said
signal distributing means and each of said filter
means for shifting a phase of said reference signal
passing therethrough.

12. An antenna device as claimed in any one
of Claims 1 to 11,
wherein each of said integrated circuit units further
comprises input terminal connected to said local
oscillating means for receiving said reference signal.

13. An antenna device as claimed in Claim 12,
wherein said coupling means comprises signal distributing means connecting said reference signal
generating means and each of said integrated circuit units at said input terminal.

14. An antenna device as claimed in Claim 13,
which further comprises a plurality of variable
phase shifters each connecting said output terminal
and said combining means for shifting a phase of
said output signal passing therethrough.

15. An antenna device as claimed in Claim 13
or 14,
wherein said coupling means further comprises a
plurality of variable phase shifters each connecting
said signal distributing means and said input terminal for shifting a phase of said reference signal
passing therethrough.

16. An antenna device as claimed in any one
of Claims 12 to 15,
wherein said combining means comprises a conductive line which is connected in common to each
of said integrated circuit units at said output terminal.

17. An antenna device as claimed in Claim 16, wherein said conductive line is connected in common to each of said integrated circuit units at said input terminal, said reference signal generating means being connected to said conductive line whereby said combining means serves as said coupling means.

18. An antenna device as claimed in Claim 17, which further comprises a filter means connecting said reference signal generating means and said conductive line so as to prevent said combined signal from entering said reference signal generating means.

19. An antenna device as claimed in Claim 18, which further comprises a plurality of variable phase shifters each connecting said output terminal and said conductive line for shifting a phase of said output signal passing therethrough.

20. An antenna device as claimed in Claim 18 or 19, which further comprises a plurality of variable phase shifters each connecting said input terminal and said conductive line for shifting a phase of said reference signal passing therethrough.

21. An antenna device as claimed in any one of Claims 1 to 20, which further comprises a housing, a circuit board mounted in said housing and having said plurality of integrated circuit units mounted thereon, said circuit board further having said combining means, said output port, said reference signal generating means, and coupling means formed thereon, and an electric connector mounted on said housing and connected to said output port.

22. An antenna device as claimed in any one of Claims 1 to 21 wherein each of said integrated circuit units comprises a reference signal receiving antenna, said reference signal generating means having a reference signal transmitting antenna so that the coupling means is consisted by antenna coupling between said reference signal receiving antenna and said reference signal transmitting antenna.

23. An antenna device as claimed in Claim 22, which further comprises a housing, a circuit board mounted in said housing and having said plurality of integrated circuit units mounted thereon and an electric connector mounted on said housing, said circuit board further having said combining means, said output port connected to said electric connector, said reference signal generating means, and said reference signal transmitting antenna formed thereon.

24. An antenna device as claimed in Claim 23, wherein said reference signal receiving antenna is formed in each of said integrated circuit units.

25. An antenna device as claimed in Claim 23, wherein said reference signal receiving antenna is formed on said circuit board.

26. An antenna device having a plurality of antenna elements for radiating a radio wave which comprises:

an input port for receiving an intermediate frequency signal;

first distributing means coupled to said input port for distributing said intermediate frequency signal to a plurality of integrated circuit units;

said plurality of integrated circuit units each comprising:

an input terminal coupled to said distributing means for receiving said intermediate frequency signal:

local oscillator means for oscillating a local signal of a predetermined frequency in synchronism with a reference signal;

mixer means coupled to said input terminal and said local oscillator means for mixing said intermediate frequency signal and said local signal to produce a transmission signal;

power amplifier means coupled to said mixer means for power amplifying said transmission signal as an amplified transmission signal; and

at least one of said antenna elements coupled to said power amplifier means for radiating said amplified transmission signal as said radio wave;

reference signal generating means for generating said reference signal; and

coupling means for coupling said local oscillating means and said reference signal generating means for supplying said reference signal to said local oscillator means.

27. An antenna device as claimed in Claim 26, which further comprises a plurality of variable phase shifters each coupled between said input terminal and said first distributing means for shifting a phase of said intermediate frequency signal passing therethrough.

28. An antenna device as claimed in Claim 26 or 27, wherein said coupling means comprises second distributing means coupled to said reference signal generating means and each of said integrated circuit units.

29. An antenna device as claimed in Claim 28, wherein said coupling means comprises a plurality of variable phase shifters each connecting said second distributing means and each of said integrated circuits for shifting a phase of said reference signal passing therethrough.

30. An antenna device as claimed in any one of Claims 26 to 29, wherein each of said integrated circuit units comprises a reference signal receiving antenna, said reference signal generating means having a reference signal transmitting antenna so that the coupling means is consisted by antenna coupling between said reference signal receiving antenna and said reference signal transmitting antenna.

FIG. 1    PRIOR ART

EP 0 359 238 A2

PRIOR ART

FIG.2A

PRIOR ART

FIG.2B

PRIOR ART

FIG.2C

PRIOR ART

FIG.2D

FIG.3   PRIOR ART

EP 0 359 238 A2

FIG.4

38

43

48

# FIG.5A

38

49    50

43

48

44    31    46  45  47

# FIG.5B

# FIG.6

# FIG.6A

## FIG.7

- 31 ANTENNA ELEMENT
- 33 AMPLIFIER
- 34 MIXER
- 36 IF AMPLIFIER
- 35 LOCAL OSCILLATOR
- 42
- 55
- MICU
- 54

## FIG.8

- 541 MICU
- 551
- 561 VARIABLE PHASE SHIFTER
- 542 MICU
- 552
- 562 VARIABLE PHASE SHIFTER
- 54n MICU
- 55n
- 56n VARIABLE PHASE SHIFTER
- 32 SIGNAL COMBINING CKT
- 40
- 57 BAND STOP FILTER
- 41 REFERENCE SIGNAL GENERATOR

FIG.9

FIG.9A

FIG.9B

FIG.10

EP 0 359 238 A2

FIG.11

FIG.11A

FIG.12

FIG.13

FIG.14

F I G.15

F I G.16

**FIG.17**

| 31 | 33 | 34 | 36 |
|---|---|---|---|
| ANTENNA ELEMENT | AMPLIFIER | MIXER | IF AMPLIFIER |

55

35

LOCAL OSCILLATOR

42

MICU

60

54'

**FIG.18**

54'1 — MICU — 551 — VARIABLE PHASE SHIFTER — 561

601

54'2 — MICU — 552 — VARIABLE PHASE SHIFTER — 562

602

32 — SIGNAL COMBINING CKT

40

54'n — MICU — 55n — VARIABLE PHASE SHIFTER — 56n

60n

BAND STOP FILTER — 57

REFERENCE SIGNAL GENERATOR — 41

54'1 —⟋⎯ | MICU | 551

601

561 —⟋ | VARIABLE PHASE SHIFTER |

| SIGNAL COMBINING CKT | 32

40

54'n —⟋⎯ | MICU | 55n

60n

56n —⟋ | VARIABLE PHASE SHIFTER |

| BAND STOP FILTER | 57

| REFERENCE SIGNAL GENERATOR | 41

## FIG.19

FIG.20

FIG.21

F I G. 22

FIG.23

FIG.24